# EUROPEAN PATENT SPECIFICATION

(11) **EP 3 911 963 B1**
(45) Date of publication and mention of the grant of the patent: **06.09.2023**
(21) Application number: 19703594.2
(22) Date of filing: 18.01.2019
(51) Int. Cl.: G01R 31/367, G01R 31/396, G01R 31/3828

(54) **ENERGY STORAGE ROLLING CAPACITY CHECK INCLUDING IN-SITU LIFETIME MODEL COMPARISON**
KONTROLLE EINER ROLLIERENDEN ENERGIESPEICHERKAPAZITÄT MIT IN-SITU LEBENSDAUERMODELLVERGLEICH
VÉRIFICATION DE CAPACITÉ DE ROULEMENT DE STOCKAGE D'ÉNERGIE COMPRENANT UNE COMPARAISON AVEC UN MODÈLE DE DURÉE DE VIE IN SITU

(43) Date of publication of application: 24.11.2021
(73) Proprietor: General Electric Company, Schenectady, NY 12345 (US)
(72) Inventor: KALITAN, Danielle, Niskayuna, NY 12309 (US); NICHOLS, Jason, M., Niskayuna, NY 12309 (US)
(74) Representative: Openshaw & Co.
(86) International application number: PCT/US2019/014283
(87) International publication number: WO 2020/149857

(56) References cited:
- US-A1- 2016 231 385
- US-A1- 2018 026 454

## Description

### BACKGROUND

Battery life is conventionally described in terms of the capacity remaining in a battery at any given time compared to the capacity of the battery
when it was newly installed or manufactured. Typically, in order for the capacity of a battery used for energy storage to be measured at a site, the entire battery system may be taken off-line (out of service), and the capacity measurement may be taken in isolation from normal operation of the battery system. This conventional procedure may take several days, and the operation of the industrial processes using this battery may be disrupted for that length of time.

US published patent application no. 2016/231385 relates to a multi-cell battery, and individual evaluation of the battery cells. Each cell is individually removed or disconnected from the battery. An adjustable cell charger and an adjustable cell load are mapped to the disconnected cell. As the charger charges the cell, an associated sensor validates acceptance of the charge. As the cell load discharges the cell, the sensor measures discharge characteristics. Operating efficiency of the selected cell is evaluated based on the measured charge acceptance and discharge characteristics.

Therefore, it would be desirable to provide a system and method that more efficiently determines energy storage capacity.

### BRIEF DESCRIPTION

According to some embodiments, a method includes providing an energy storage device including two or more energy storage elements; initiating execution of an energy storage capacity module operative to test a capacity of a first energy storage element; removing the storage element from service, while maintaining service of the energy storage device; measuring a capacity of the removed storage element; receiving the measured capacity at a lifing model; executing the lifing model to generate an output; and manipulating operation of the energy storage device based on the generated output.

According to some embodiments, a system includes an energy storage device including two or more energy storage elements; an energy storage capacity module operative to test a capacity of a first energy storage element; a memory for storing program instructions; an energy storage processor, coupled to the memory, and in communication with the energy storage capacity module, and operative to execute program instructions to: initiate execution of the energy storage capacity module; remove the storage element from service, while maintaining service of the energy storage device; measure a capacity of the removed storage element; receive the measured capacity at a lifing model; execute the lifing model to generate an output; and manipulate operation of the energy storage device based on the generated output.

According to some embodiments, a non-transitory computer-readable medium stores instructions that, when executed by a computer processor, cause the computer processor to perform a method including: initiating execution of an energy storage capacity module operative to test a capacity of a first energy storage element of an energy storage device; removing the storage element from service, while maintaining service of the energy storage device; measuring a capacity of the removed storage element; receiving the measured capacity at a lifing model; executing the lifing model to generate an output; and manipulating operation of the energy storage device based on the generated output.

A technical effect of some embodiments of the invention is an improved technique and system for checking the energy storage capacity of an element in-situ. Some embodiments provide for measuring energy storage capacity whereby less than all of the energy storage unit is taken off-line, and therefore a majority of the energy storage unit may be used to supply energy while the capacity check is occurring. Some embodiments provide for a more accurate energy storage unit life model, as real-time may be provided to the model and the amount of validation instances may be greater than compared to conventional life models. Some embodiments may provide for users having an increased use of the energy storage unit, as well as any features that result from increased use (e.g., increased time for revenue making).

With this and other advantages and features that will become hereinafter apparent, a more complete understanding of the nature of the invention can be obtained by referring to the following detailed description and to the drawings appended hereto.

Other embodiments are associated with systems and/or computer-readable medium storing instructions to perform any of the methods described herein.

### DRAWINGS

FIG. 1 illustrates a prior art energy storage unit.
FIG. 2 illustrates a system according to some embodiments.
FIG. 3 illustrates a flow diagram according to some embodiments.
FIG. 4 illustrates s a block diagram of a system according to some embodiments.
FIG. 5 illustrates a discharge of energy between storage elements according to some embodiments.

### DETAILED DESCRIPTION

A battery energy storage system (BESS) is a system that stores energy via the use of battery technology for the energy to be used at a later time. The BESS may include a plurality of battery cells. A portion of the battery cells may be grouped together to form a string, and the strings may be grouped together into a rack of one or more battery modules. The racks of battery modules may be connected together and may act as one large battery. The battery cells may degrade over time. Historically, if an owner/operator of the BESS wanted to determine the capacity of the BESS, to determine an amount of remaining battery life, the operator would have to disrupt the normal operation of the BESS and conduct a specialized capacity test, whereby the entire BESS is taken "off-line" (e.g., out of service). The capacity measurement is typically taken in isolation from normal operation of the BESS. Depending on the size of the energy storage site and the number of BESSes to be tested, this conventional procedure may take several days and even up to one week. This may be inconvenient because any time that the BESS is not in normal operation, the owner of the site may not be able to provide energy storage services to clients.

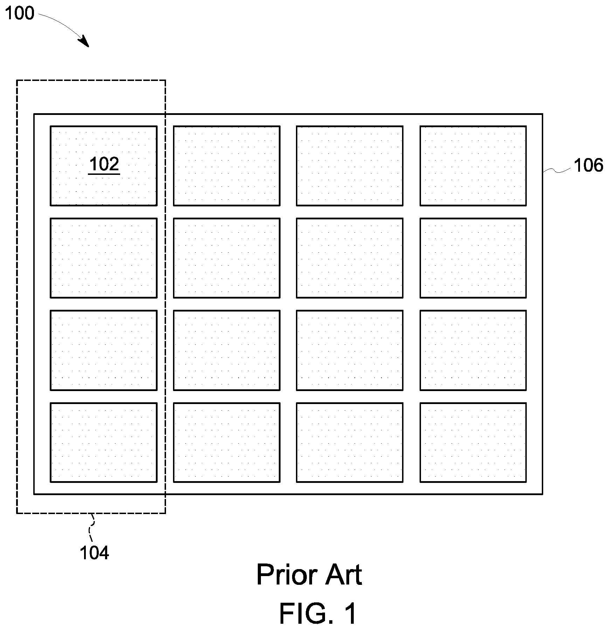

FIG. 1 illustrates a BESS 100 including battery cells 102, strings 104 and racks 106. Typically, the capacity of the entire system 100 may be checked at the same time, so the entire BESS 100 is taken "off-line" or out of service for the test. As shown herein, the shaded battery cells 102 are the cells taken off-line for testing.

Embodiments provide a method and system for measuring energy storage unit capacity, whereby a small portion (i.e. less than all) of the cells may be taken off-line for the measurement, and therefore the majority of the BESS may be in operation while the capacity check occurs.

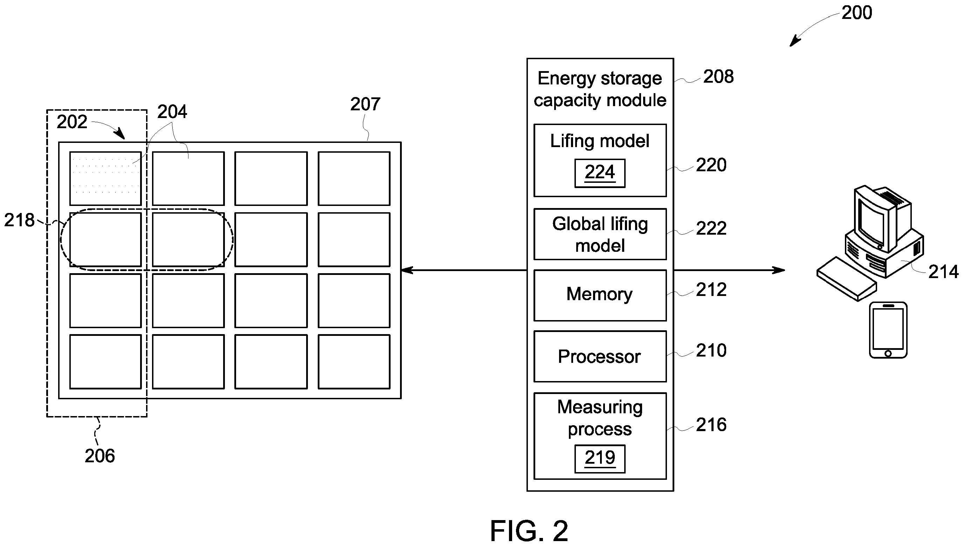

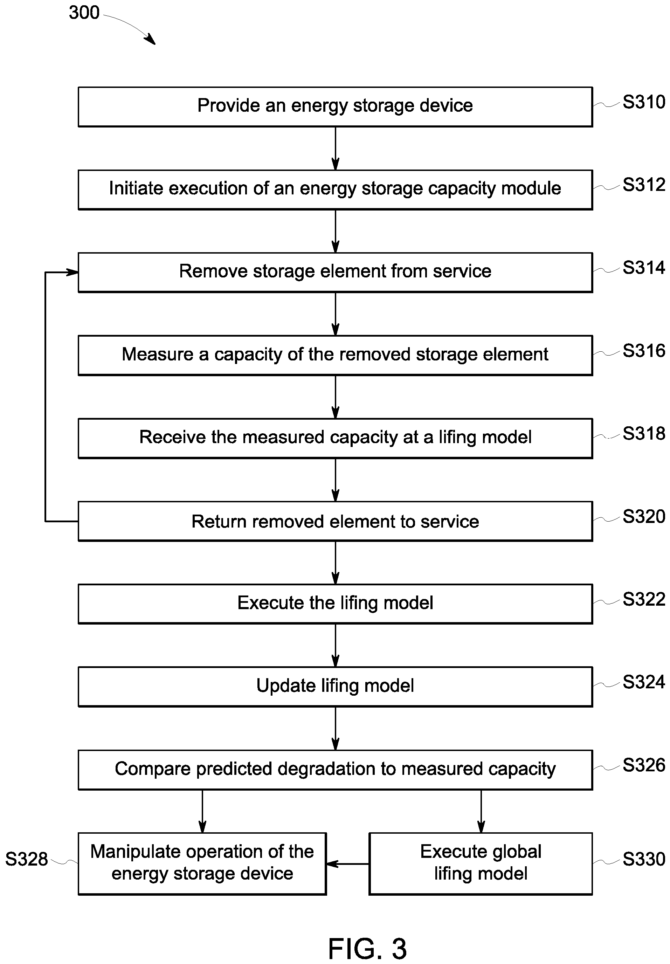

Turning to FIGS. 2-3, a system 200 and flow diagram 300 of examples of operation according to some embodiments are provided. In particular, FIG. 3 provides a flow diagram of a process 300, according to some embodiments. Process 300 and other processes described herein may be performed using any suitable combination of hardware (e.g., circuit(s)), software or manual means. In one or more embodiments, the system 200 is conditioned to perform the process 300 such that the system is a special-purpose element configured to perform operations not performable by a general-purpose computer or device. Software embodying these processes may be stored by any non-transitory tangible medium including a fixed disk, a floppy disk, a CD, a DVD, a Flash drive, or a magnetic tape. Examples of these processes will be described below with respect to embodiments of the system, but embodiments are not limited thereto.

Initially, at S310, an energy storage device 202, such as a BESS, is provided. The energy storage device 202 may include two or more energy storage elements, including, but not limited to, cells 204, strings 206, racks of modules 207 ("racks"). In one or more embodiments, the energy storage device 202 may be a battery, or any other suitable energy storage device. The energy storage device 202 may be one of a plurality of energy storage devices at a power plant, or may be an individual energy storage device. The energy storage devices may provide energy to at least one of a grid, customers, etc.

Then in S312, execution of an energy storage capacity module 208 is initiated. In one or more embodiments, the energy storage capacity module 208 may be operative to test a capacity of the energy storage device 202. The energy storage capacity module 208 may test the capacity of any of the energy storage elements (e.g., cells, strings, racks, etc.) as determined by an operator, or any other suitable party. In one or more embodiments, the energy storage capacity module 208 may include one or more processing elements 210 and a memory 212. The processor 210 may, for example, be a conventional microprocessor, and may operate to control the overall functioning of the energy storage capacity module 208. In one or more embodiments, the energy storage capacity module 208 may include a communication controller for allowing the processor 210, and hence the energy storage capacity module 208, to engage in communication over data networks with other devices (e.g., the energy storage device 202) or other user platforms 214. In one or more embodiments, the one or more memory and/or data storage devices 212, may comprise any combination of one or more of a hard disk drive, RAM (random access memory), ROM (read only memory), flash memory, etc. The memory/data storage devices 212 may store software that programs the processor 210 and the energy storage capacity module 208 to perform functionality as described herein.

A user/operator may access the system 200 via one of the user platforms 214 (a control system, a desktop computer, a laptop computer, a personal digital assistance a tablet, a smartphone, etc.) to view information and/or manage the energy storage device 202 in accordance with any of the embodiments described herein.

In one or more embodiments, the initiation of the execution of the energy storage capacity module 208 may be based on a capacity check condition having been met. The degradation of the storage element may be from mechanical, chemical, electrochemical and/or electrochemomechanical degradation modes. Each of these modes may be temperature/time dependent. Some non-exhaustive examples of capacity check conditions include a scheduled check and an event-based check. With the scheduled check, the energy storage capacity module 208 may be executed to determine the energy storage capacity of the energy storage device 202 at regularly scheduled intervals (e.g. once a month, once every six months, etc.), as determined by the operator, or other suitable party. With the event-based checks, the energy storage capacity module 208 may be executed when the battery cannot hold as much charge as expected. For example, a model of the BESS system may indicate that a given amount of degradation is to be expected, and when the BESS starts performing in a way that is inconsistent with that expected amount of degradation, an event-based check may be initiated. An opportunistic check is another non-exhaustive example of an event-based check. In one or more embodiments, an opportunistic check may refer to an event or condition that exists when it would be easier to take a measurement of the capacity of the energy storage device. For example, when the system 200 is scheduled to be idle for twelve hours, this may be a condition whereby it is easier to take the measurement of the device, than when the system is not idle, and a check performed at this time may be an opportunistic check. In one or more embodiments, an opportunistic process may be used to anticipate the timing of an opportunistic check. In one or more embodiments, the opportunistic process may be used to bundle elements together in a dynamic balance to ensure that the element under test may be used for the capacity check. As a non-exhaustive example, there is an upcoming scheduled discharge event, and a group of four elements that can service the discharge event. However, discharging all four elements will only provide 75% discharge for each element, which may not be adequate for a capacity check. The opportunistic process solves this problem by bundling only three of the elements such that the discharge event uses 100% of each element's capacity yielding a successful capacity check.

It is noted that the capacity check condition may change based on changing conditions. For example, if the capacity check condition was scheduled every six months, and based on the most recent capacity check, the energy storage device is degrading at a faster rate than expected, the capacity check condition may be changed to be scheduled every 2 months.

Turning back to the process, 300, in S314 the storage element is removed from service. As described above, in one or more embodiments, the storage element that is removed from service is a sub-portion of the energy storage device (i.e., less than all of the storage elements of the storage device), while the non-removed portion of the energy storage device 202 remains in service. When the storage element is removed from service, the energy storage device may switch to another power source, for example, or the remainder of the energy storage device may maintain the service requirement. As shown in FIG. 2, for example, the shaded battery cell 204 is removed from service. While the non-exhaustive example described herein has the storage element removed from service as the battery cell, any other suitable element (e.g., string, rack, etc.) may be removed.

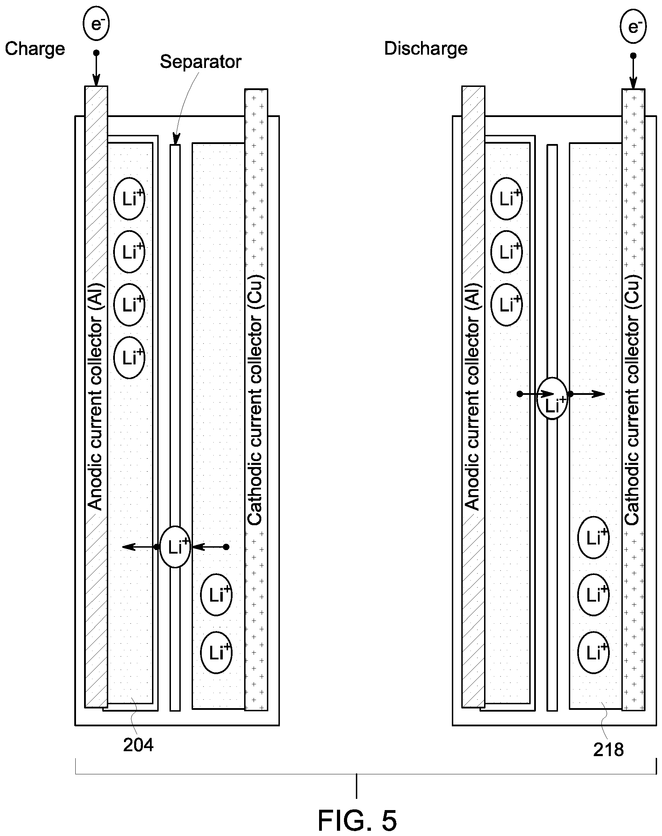

Next, in S316, a capacity of the removed storage element may be measured by a measuring process 216. In one or more embodiments, to measure the capacity of the removed storage element, the removed storage element may be discharged to one or more available discharge cells 218, marked by a dotted circle in FIG. 2, and shown in FIG. 5. It is noted that the discharge cells 218 are part of the energy storage device. In one or more embodiments, the discharge cells 218 may be selected by the energy storage capacity module 208. The energy storage capacity module 208 may have a state of energy measurement available for all of the discharge cells 218. For example, if the discharge cells are sitting at half voltage range, then they can receive 50% more energy. The energy storage capacity module 208 determines there are enough available discharge cells 218 to receive the discharge from the removed storage element.

It is noted that even when the removed storage element being tested is a string, for example, the individual cells that make up the string are discharged. Physically, discharge may occur at the next to lowest level of control available in a system. For example, if there is cell-level control, capacity may be measured per string and discharge may occur from strings to cells. Then capacity may be measured at the string level and discharge occurs at the cell level. In one or more embodiments, the unit of capacity is measured on a collection of cells. The collection may have a cell number greater than one, and collections with more than one cell may have cells arranged in series, parallel, or combinations thereof with at least one set of cells in series in the collection. As such, in one or more embodiments, capacity of the collection may be measured, instead of the cell.

As a non-exhaustive example, if a system includes 100 cells, the cells maybe organized as a string, with five cells in parallel, a module of two strings in series, and a rack of five modules in series. The system may include ten modules, and this may be the lowest level at which capacity may be measured in this arrangement. A rack may be used to charge the module up, since the rack may have a larger driving voltage than the module. Then the module may be drained into empty or partially empty strings (discharge cells), since the module has a larger driving voltage than the string.

It is further noted that the removed storage element is not physically removed from the energy storage device, rather the removed storage element is electrically isolated from the energy storage device. After drainage, the removed storage element is "effectively empty," i.e., it may be empty at some minimum reference voltage achievable by the control system. It is noted that more energy may be discharged from the empty removed storage element by reducing the voltage until the battery fails to get the absolute capacity. However, discharging energy from the empty element may not be needed when the capacity is measured over a defined reference voltage range and how that capacity changes over time, as described by one or more embodiment. As a non-exhaustive example, there may be five available discharge cells to accept the drained energy from the removed storage element. As the energy from the removed storage element is being discharged to the discharge cells, the Amps (energy) that are discharged are measured. Capacity may be measured as the amount of energy discharged from the collection elements over a defined voltage range. For example, to make a practical measurement of the capacity, a fixed constant-current load of X amperes is applied and a clock is started. The current that is being drawn by the load is measured (measured current X amperes). The voltage on the cell is continuously measured, and when it reaches the end of discharge voltage, the clock is stopped at time T. The constant-current value of X amperes multiplied by the measured time T will result in a measured capacity 219 of X x T. After drainage, the available discharge cells may be full. Then the filled discharge cells 218 return the energy to the removed storage element to push the removed storage element to a full charge. It is noted that while a collection of cells (e.g., removed storage element and discharge cells) may be used to determine the capacity of the removed storage element, there may be a net zero transfer of energy from the energy storage device, except for that lost to efficiency and transfer between the cells.

Then in S318, the measured capacity 219 is received at a lifing model 220, and the removed storage element is returned to service in S320. It is noted that the order of S318 and S320 may occur at the same time, substantially the same time, or at different times.

The lifing model 220 may be a degradation/life model that calculates either a predicted degradation/total time to failure or predicted number of cycles to failure for a particular energy storage element based on one or more input parameters including, but not limited to, temperature-based acceleration, voltage-based acceleration, and throughput-based acceleration. In one or more embodiments, the lifing model 220 may be a digital twin that may be unique to the removed storage element. One or more embodiments may also provide a global lifing model 222, as described further below.

The lifing model 220 may be executed in S322. The executed lifing model 220 may output a predicted degradation 224 for that removed storage element. In one or more embodiments, the initial parameters may be supplied to the lifing model 220 by a developer or other suitable party. Subsequent to S322, the lifing model 220 may be updated with the parameters from the measured capacity in S324. Updating the lifing model 220 may provide for a continuous learning system that provides for current energy storage device estimates. In one or more embodiments, the lifing model 220 maybe asset-specific.

Then the predicted degradation 224 from the lifing model 220 may be compared to measured capacity 219 of the removed storage element in S326. In one or more embodiments, the energy storage capacity module 208 may determine whether the difference between the predicted degradation 224 and the measured capacity 219 are within a threshold value.

Next, operation of the energy storage device 202 may be manipulated in S328. In one or more embodiments, the manipulation may be based on the comparison to the threshold value. Based on the results of the in-situ life model calculation, the operator of the energy storage system may change their operation of the energy storage device. For example, they may use the energy storage device more because they had more life left than they thought they did (and, for example, there may be more money to be made), or they may use it less because there is less life remaining than they thought there was, and they want the battery to last until the expected original end of life.

In one or more embodiments, after the removed energy storage element is returned to service in S320, a next or second energy storage element from the energy storage device 202 may be removed from service for capacity measurement, as described above with respect to S322-S326. It is noted that in one or more embodiments, this process of checking the next energy storage elements may persist until all of the energy storage elements in the energy storage device are tested, or until some other user-defined stopping criteria is met. Then prior to manipulation of the energy storage device 202 in S328, the energy storage capacity module 208 may execute a global lifing model 222 (e.g., lifing/digital twin model of the energy storage device) to analyze the distribution of measured capacities over two or more energy storage elements 202 to determine a degradation estimate for the energy storage device in S330. In one or more embodiments the global lifing model may provide an average degradation rate and standard deviation by which to compare the individual energy storage elements forming the energy storage device.

In one or more embodiments, the confidence level may be used to trigger additional measurements. As described above, the system may include the global lifing model, and capacity checks may be received from the energy storage elements forming the energy storage device to update the global lifing model. When the predictions made by the global lifing model begin to drift from the prior predictions, the energy storage capacity module 208 may determine the liklihood of an output from the current model given an output of the prior model. If the liklihood the outputs will be the same is high, then the model may receive a high confidence level. If the liklihood the outputs will be the same is low (e.g., below a threshold), the model may receive a low confidence level, which may indicate the model has drifted. When the model has drifted, the drift data may be reported to a user via the user platforms 214, and the user may then decide to do capacity checks at individual energy storage elements to determine the cause of the drift. In one or more embodiments, when the model has drifted, the energy storage capacity module 208 may automatically execute capacity checks at individual energy storage elements (e.g., non-schedule condition) to determine the cause of the drift.

In one or more embodiments, the global lifing model for the energy storage device and the confidence level may be used to determine an interval for testing the capacity of the energy storage elements. For example, if there is a high confidence that the global lifing model is accurate in the predicted degradation for the energy storage element, then a less frequent capacity check may be scheduled. As a non-exhaustive example, if the confidence level in the model is more than 85%, then a user does not have to schedule capacity checks and may instead rely on non-scheduled capacity checks (e.g., event-based checks). As another non-exhaustive example, if the measured capacity exceeds the predicted degraded capacity, non-scheduled capacity checks (e.g., event-based checks) may be executed instead of scheduling capacity checks. If there is a low confidence that the global lifing model is accurate in predicting the degraded capacity, or that the storage device may be nearing a failure point, for example, more frequent capacity checks may be scheduled.

The process 300 may then return to S328 to manipulate operation of the energy storage device. In one or more embodiments, the energy storage capacity module 208 may analyze the distribution to determine whether measured capacity for an individual energy storage element is based on randomness within the system or skewed by some other element. As a non-exhaustive example, if one energy storage element is situated in a sunny location and another energy storage element is situated in a shady location, the sunny location energy storage element may degrade faster than the shady location energy storage element. As such, the energy storage capacity module 208 may shift the operation of the energy storage device (e.g., use less of the elements that degrade faster and use more of the elements that degrade slower) to generate a longer life for the device in a process that may be referred to as "load-balancing".

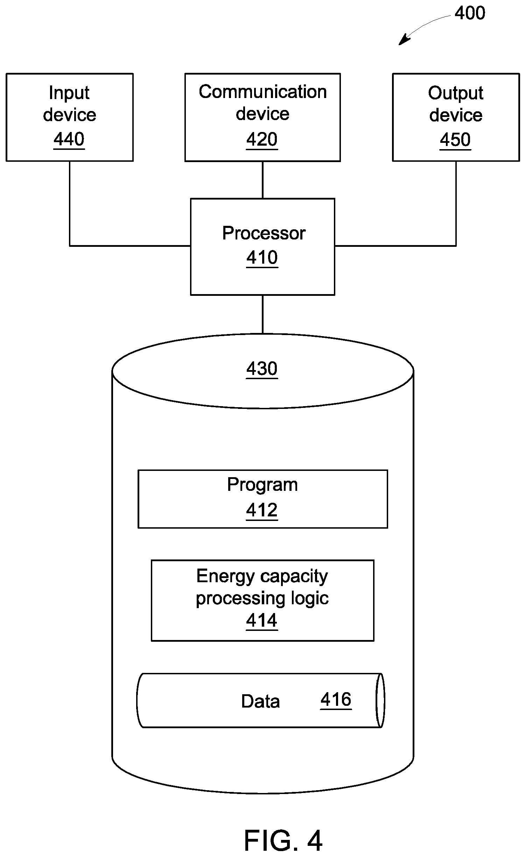

Note the embodiments described herein may be implemented using any number of different hardware configurations. For example, FIG. 4 illustrates an energy capacity processing platform 400 that may be, for example, associated with the system 200 of FIG. 2. The energy storage processing platform 400 comprises an energy capacity processor 410 ("processor"), such as one or more commercially available Central Processing Units (CPUs) in the form of one-chip microprocessors, coupled to a communication device 420 configured to communicate via a communication network (not shown in FIG. 4). The communication device 420 may be used to communicate, for example, with one or more users. The energy capacity processing platform 400 further includes an input device 440 (e.g., a mouse and/or keyboard to enter information about the measurements and/or assets) and an output device 450 (e.g., to output and display the data and/or recommendations).

The processor 410 also communicates with a memory/storage device 430. The storage device 430 may comprise any appropriate information storage device, including combinations of magnetic storage devices (e.g., a hard disk drive), optical storage devices, mobile telephones, and/or semiconductor memory devices. The storage device 430 may store a program 412 and/or energy capacity processing logic 414 for controlling the processor 410. The processor 410 performs instructions of the programs 412, 414, and thereby operates in accordance with any of the embodiments described herein. For example, the processor 410 may determine a capacity for an energy storage element to manipulate the operation of an energy storage device.

The programs 412, 414 may be stored in a compressed, uncompiled and/or encrypted format. The programs 412, 414 may furthermore include other program elements, such as an operating system, a database management system, and/or device drivers used by the processor 410 to interface with peripheral devices.

As used herein, information may be "received" by or "transmitted" to, for example: (i) the platform 400 from another device; or (ii) a software application or module within the platform 400 from another software application, module, or any other source.

As will be appreciated by one skilled in the art, aspects of the present invention may be embodied as a system, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer readable program code embodied thereon.

The flowchart and block diagrams in the Figures illustrate the architecture, functionality, and operation of possible implementations of systems, methods and computer program products according to various embodiments of the present invention. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

It should be noted that any of the methods described herein can include an additional step of providing a system comprising distinct software modules embodied on a computer readable storage medium; the modules can include, for example, any or all of the elements depicted in the block diagrams and/or described herein; by way of example and not limitation, a geometrical compensation module. The method steps can then be carried out using the distinct software modules and/or sub-modules of the system, as described above, executing on one or more hardware processors 410 (FIG. 4). Further, a computer program product can include a computer-readable storage medium with code adapted to be implemented to carry out one or more method steps described herein, including the provision of the system with the distinct software modules.

This written description uses examples to disclose the invention, including the preferred embodiments, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims. Aspects from the various embodiments described, as well as other known equivalents for each such aspects, can be mixed and matched by one of ordinary skill in the art to construct additional embodiments and techniques in accordance with principles of this application.

## Claims

1. A method comprising the following steps, carried out in the following sequence:
providing an energy storage device (310) including at least a first energy storage element and a second energy storage element;
initiating execution of an energy storage capacity module (312) configured to test a capacity of the first energy storage element;
removing the first energy storage element from service (314), while maintaining service of the energy storage device;
measuring a capacity of the removed first energy storage element (316);
receiving the measured capacity at a lifing model (318);
executing the lifing model to generate an output (322); and
manipulating operation of the energy storage (328) device based on the generated output.

2. The method of claim 1, further comprising:
determining a capacity check condition is present prior to initiating execution of the energy storage capacity module.

3. The method of claim 1, further comprising:
returning the removed first storage element to service.

4. The method of claim 3, further comprising:
removing the second energy storage element from service to test the capacity of the second energy storage element.

5. The method of claim 1, wherein the generated output is the predicted capacity of the energy storage element.

6. The method of claim 1, further comprising:
executing a global lifing model for the energy storage device (330).

7. The method of claim 6, wherein the generated output of the executed global lifing model is the predicted capacity of the energy storage device.

8. A system comprising:
an energy storage device including at least a first energy storage element and a second energy storage element
an energy storage capacity module configured to test a capacity of the first energy storage element;
a memory for storing program instructions;
an energy storage processor, coupled to the memory, and in communication with the energy storage capacity module, and configured to execute program instructions to carry out the following steps in in the following sequence:
initiate execution of the energy storage capacity module (312);
remove the first energy storage element from service (314), while maintaining service of the energy storage device;
measure a capacity of the removed first energy storage element (316);
receive the measured capacity at a lifing model (318);
execute the lifing model (322) (322) to generate an output; and
manipulate operation of the energy storage device (328) based on the generated output.

9. The system of claim 8, wherein the first energy storage element is at least one of a cell, a string, and a rack of a battery.

10. The system of claim 8, further comprising program instructions which, when executed by the energy storage processor, cause the energy storage processor to:
determine a capacity check condition is present prior to initiating execution of the energy storage capacity module.

11. The system of claim 8, further comprising program instructions which, when executed by the energy storage processor, cause the energy storage processor to:
return the removed first storage element to service.

12. The system of claim 11, further comprising program instructions which, when executed by the energy storage processor, cause the energy storage processor to:
remove the second energy storage element from service to test the capacity of the second energy storage element.

13. The system of claim 8, wherein the generated output is the predicted capacity of the first energy storage element.

14. The system of claim 8, further comprising program instructions which, when executed by the energy storage processor, cause the energy storage processor to:
execute a global lifing model for the energy storage device (330).

15. The system of claim 14, wherein the generated output of the executed global lifing model is the predicted capacity of the energy storage device.

## Patentansprüche

1. Verfahren, umfassend die folgenden Schritte, die in der folgenden Reihenfolge ausgeführt werden:
Bereitstellen einer Energiespeichervorrichtung (310), die mindestens ein erstes Energiespeicherelement und ein zweites Energiespeicherelement einschließt;
Einleiten einer Ausführung eines Energiespeicherkapazitätsmoduls (312), das konfiguriert ist, um eine Kapazität des ersten Energiespeicherelements zu testen;
Entfernen des ersten Energiespeicherelements aus dem Betrieb (314), während der Betrieb der Energiespeichervorrichtung beibehalten wird;
Messen einer Kapazität des entfernten ersten Energiespeicherelements (316);
Empfangen der gemessenen Kapazität an einem Lebensdauermodell (318);
Ausführen des Lebensdauermodells, um einen Ausgang (322) zu erzeugen; und
Manipulieren eines Einsatzes der Energiespeichervorrichtung (328) basierend auf der erzeugten Ausgabe.

2. Verfahren nach Anspruch 1, ferner umfassend:
Bestimmen, dass eine Kapazitätsprüfungsbedingung vor dem Einleiten der Ausführung des Energiespeicherkapazitätsmoduls vorhanden ist.

3. Verfahren nach Anspruch 1, ferner umfassend:
Zurückführen des entfernten ersten Speicherelements in den Betrieb.

4. Verfahren nach Anspruch 3, ferner umfassend:
Entfernen des zweiten Energiespeicherelements aus dem Betrieb, um die Kapazität des zweiten Energiespeicherelements zu testen.

5. Verfahren nach Anspruch 1, wobei die erzeugte Ausgabe die vorhergesagte Kapazität des Energiespeicherelements ist.

6. Verfahren nach Anspruch 1, ferner umfassend:
Ausführen eines globalen Lebensdauermodells für die Energiespeichervorrichtung (330).

7. Verfahren nach Anspruch 6, wobei die erzeugte Ausgabe des ausgeführten globalen Lebensdauermodells die vorhergesagte Kapazität der Energiespeichervorrichtung ist.

8. System, umfassend:
eine Energiespeichervorrichtung, die mindestens ein erstes Energiespeicherelement und ein zweites Energiespeicherelement einschließt
ein Energiespeicherkapazitätsmodul, das konfiguriert ist, um eine Kapazität des ersten Energiespeicherelements zu testen;
einen Speicher zum Speichern von Programmanweisungen;
einen Energiespeicherprozessor, der mit dem Speicher gekoppelt ist und mit dem Energiespeicherkapazitätsmodul in Kommunikation steht und konfiguriert ist, um Programmanweisungen auszuführen, um die folgenden Schritte in der folgenden Reihenfolge durchzuführen:
Einleiten der Ausführung des Energiespeicherkapazitätsmoduls (312);
Entfernen des ersten Energiespeicherelements aus dem Betrieb (314), während der Betrieb der Energiespeichervorrichtung beibehalten wird;
Messen einer Kapazität des entfernten ersten Energiespeicherelements (316);
Empfangen der gemessenen Kapazität an einem Lebensdauermodell (318);
Ausführen des Lebensdauermodells (322) (322), um einen Ausgang zu erzeugen; und
Manipulieren eines Einsatzes der Energiespeichervorrichtung (328) basierend auf der erzeugten Ausgabe.

9. System nach Anspruch 8, wobei das erste Energiespeicherelement mindestens eines von einer Zelle, einer Kette und einem Gestell einer Batterie ist.

10. System nach Anspruch 8, ferner umfassend Programmanweisungen, die, wenn sie durch den Energiespeicherprozessor ausgeführt werden, den Energiespeicherprozessor veranlassen zum:
Bestimmen, dass eine Kapazitätsprüfungsbedingung vor dem Einleiten der Ausführung des Energiespeicherkapazitätsmoduls vorhanden ist.

11. System nach Anspruch 8, ferner umfassend Programmanweisungen, die, wenn sie durch den Energiespeicherprozessor ausgeführt werden, den Energiespeicherprozessor veranlassen zum:
Zurückführen des entfernten ersten Speicherelements in den Betrieb.

12. System nach Anspruch 11, ferner umfassend Programmanweisungen, die, wenn sie durch den Energiespeicherprozessor ausgeführt werden, den Energiespeicherprozessor veranlassen zum:
Entfernen des zweiten Energiespeicherelements aus dem Betrieb, um die Kapazität des zweiten Energiespeicherelements zu testen.

13. System nach Anspruch 8, wobei die erzeugte Ausgabe die vorhergesagte Kapazität des ersten Energiespeicherelements ist.

14. System nach Anspruch 8, ferner umfassend Programmanweisungen, die, wenn sie durch den Energiespeicherprozessor ausgeführt werden, den Energiespeicherprozessor veranlassen zum:
Ausführen eines globalen Lebensdauermodells für die Energiespeichervorrichtung (330).

15. System nach Anspruch 14, wobei die erzeugte Ausgabe des ausgeführten globalen Lebensdauermodells die vorhergesagte Kapazität der Energiespeichervorrichtung ist.

## Revendications

1. Procédé comprenant les étapes suivantes, réalisées dans l'ordre suivant :
la fourniture d'un dispositif de stockage d'énergie (310) comportant au moins un premier élément de stockage d'énergie et un second élément de stockage d'énergie ;
le lancement de l'exécution d'un module de capacité de stockage d'énergie (312) configuré pour tester une capacité du premier élément de stockage d'énergie ;
la mise hors service (314) du premier élément de stockage d'énergie, tout en maintenant en service le dispositif de stockage d'énergie ;
la mesure d'une capacité du premier élément de stockage d'énergie (316) retiré ;
la réception de la capacité mesurée au niveau d'un modèle de durée de vie (318) ;
l'exécution du modèle de durée de vie pour produire un résultat (322) ; et
la manipulation du fonctionnement du dispositif de stockage d'énergie (328) sur la base du résultat produit.

2. Procédé selon la revendication 1, comprenant en outre :
la détermination du fait qu'une condition de vérification de capacité est présente avant le lancement de l'exécution du module de capacité de stockage d'énergie.

3. Procédé selon la revendication 1, comprenant en outre :
le remise en service du premier élément de stockage retiré.

4. Procédé selon la revendication 3, comprenant en outre :
la mise hors service du second élément de stockage d'énergie pour tester la capacité du second élément de stockage d'énergie.

5. Procédé selon la revendication 1, dans lequel le résultat produit est la capacité prédite de l'élément de stockage d'énergie.

6. Procédé selon la revendication 1, comprenant en outre :
l'exécution d'un modèle global de durée de vie pour le dispositif de stockage d'énergie (330).

7. Procédé selon la revendication 6, dans lequel le résultat produit du modèle global de durée de vie exécuté est la capacité prédite du dispositif de stockage d'énergie.

8. Système comprenant :
un dispositif de stockage d'énergie comportant au moins un premier élément de stockage d'énergie et un second élément de stockage d'énergie
un module de capacité de stockage d'énergie configuré pour tester une capacité du premier élément de stockage d'énergie ;
une mémoire permettant de stocker des instructions de programme ;
un processeur de stockage d'énergie, couplé à la mémoire, et en communication avec le module de capacité de stockage d'énergie, et configuré pour exécuter des instructions de programme afin de réaliser les étapes suivantes dans l'ordre suivant :
le lancement de l'exécution du module de capacité de stockage d'énergie (312) ;
la mise hors service (314) du premier élément de stockage d'énergie, tout en maintenant en service le dispositif de stockage d'énergie ;
la mesure d'une capacité du premier élément de stockage d'énergie (316) retiré ;
la réception de la capacité mesurée au niveau d'un modèle de durée de vie (318) ;
l'exécution du modèle de durée de vie (322) (322) pour produire un résultat ; et
la manipulation du fonctionnement du dispositif de stockage d'énergie (328) sur la base du résultat produit.

9. Système selon la revendication 8, dans lequel le premier élément de stockage d'énergie est au moins l'un parmi une cellule, une chaîne et un support de batterie.

10. Système selon la revendication 8, comprenant en outre des instructions de programme qui, lorsqu'elles sont exécutées par le processeur de stockage d'énergie, amènent le processeur de stockage d'énergie à :
déterminer la présence d'une condition de vérification de capacité avant de lancer l'exécution du module de capacité de stockage d'énergie.

11. Système selon la revendication 8, comprenant en outre des instructions de programme qui, lorsqu'elles sont exécutées par le processeur de stockage d'énergie, amènent le processeur de stockage d'énergie à :
remettre en service le premier élément de stockage retiré.

12. Système selon la revendication 11, comprenant en outre des instructions de programme qui, lorsqu'elles sont exécutées par le processeur de stockage d'énergie, amènent le processeur de stockage d'énergie à :
mettre hors service le second élément de stockage d'énergie pour tester la capacité du second élément de stockage d'énergie.

13. Système selon la revendication 8, dans lequel le résultat produit est la capacité prédite du premier élément de stockage d'énergie.

14. Système selon la revendication 8, comprenant en outre des instructions de programme qui, lorsqu'elles sont exécutées par le processeur de stockage d'énergie, amènent le processeur de stockage d'énergie à :
exécuter un modèle global de durée de vie pour le dispositif de stockage d'énergie (330).

15. Système selon la revendication 14, dans lequel le résultat produit du modèle global de durée de vie exécuté est la capacité prédite du dispositif de stockage d'énergie.
